# EUROPÄISCHE PATENTSCHRIFT

(11) **EP 0 974 681 B1**
(45) Veröffentlichungstag und Bekanntmachung des Hinweises auf die Patenterteilung: **17.10.2001**
(21) Anmeldenummer: 99113482.6
(22) Anmeldetag: 13.07.1999
(51) Int. Cl.: C23C 14/54, G01L 27/00

(54) **Verfahren und Einrichtung zur Kalibrierung des Gasdruckes in einem Vakuum-Arbeitsbehälter (Vakuum-Beschichtungskammer resp. Rezipienten)**
Method and apparatus for calibrating the gas pressure in a vacuum working chamber (vacuum coating chamber or recipient)
Methode et dispositif pour calibrer la pression de gaz dans une chambre de traitement à vacuum (chambre de dépôt à vacuum ou récipient)

(30) Priorität: 14.07.1998 CH 150798
(43) Veröffentlichungstag der Anmeldung: 26.01.2000
(73) Patentinhaber: Satis Vacuum Industries Vertriebs - AG, 6341 Baar (CH)
(72) Erfinder: Suter, Rudolf, 6048 Horw (CH)
(74) Vertreter: Petschner, Goetz

(56) Entgegenhaltungen:
- PATENT ABSTRACTS OF JAPAN vol. 016, no. 454 (P-1425), 21. September 1992 (1992-09-21) & JP 04 160357 A (HITACHI LTD), 3. Juni 1992 (1992-06-03)
- PATENT ABSTRACTS OF JAPAN vol. 005, no. 058 (C-051), 21. April 1981 (1981-04-21) & JP 56 009369 A (MATSUSHITA ELECTRIC IND CO LTD), 30. Januar 1981 (1981-01-30)

## Beschreibung

Die vorliegende Erfindung betrifft ein Verfahren zur Kalibrierung des Gasdruckes in einem gasdicht verschliessbaren, evakuierbaren und mit einer Atmosphäre aus inertem Gas versehbaren Vakuum-Arbeitsbehälter (Vakuum-Beschichtungskammer resp. Rezipienten).

Bei Anlagen zur Behandlung von Gütern, insbesondere zur Beschichtung von Substraten (Schichtträgem) für die Optik, Elektronik, Werkzeugtechnik u.a. mit allen bekannten Vakuum-Beschichtungsverfahren, wie thermische Bedampfung, Sputtem, CVD u.a., welche einen gasdicht verschliessbaren, evakuierbaren und mit einer Atmosphäre aus inertem Gas versehbaren Rezipienten umfassen, kommt der exakten Kenntnis des herrschenden Gasdruckes im Rezipienten innerhalb eines Arbeits- resp. Behandlungszyklus eine wesentliche Bedeutung zu, um ein qualitativ hochstehendes Beschichtungsergebnis zu erreichen.

Bisherige Massnahmen, um das inerte Gas, beispielsweise Sauerstoff O2, Stickstoff N2 oder Argon Ar, in den Rezipienten dosiert einzubringen, etwa mittels einem, von einem lonisationsmanometer gesteuterten Gasdosierventil für Hochvakuumanlagen, sind nicht geeignet, den heutigen Ansprüchen an einen vorgegebenen konstanten, exakt einzuhaltenden Gasdruck im Rezipienten innerhalb eines Arbeits- resp. Behandlungszyklus für ein qualitativ hochstehendes Beschichtungsergebnis zu genügen, siehe hierzu z.B. JP-A-56009369.

Aufgabe der vorliegenden Erfindung ist deshalb die Schaffung eines Verfahrens zur Kalibrierung des Gasdruckes in einem gasdicht verschliessbaren, evakuierbaren und mit einer Atmosphäre aus inertem Gas versehbaren Vakuum-Arbeitsbehälter (Rezipienten), das geeignet ist, eine vorgegebene konstante Gaskonzentration im Rezipienten innerhalb eines Arbeits- resp. Behandlungszyklus wiederholbar zu gewährleisten.

Dies wird erfindungsgemäss dadurch erreicht, dass, für einen Arbeitszyklus,
a) der Rezipient evakuiert und der Restgasdruck gemessen wird, um als Restgas-Signal einem Rechner zugeführt zu werden,
b) dann mittels Rechner aus dem Restgas-Signal und einem dem Rechner vorgegebenen Arbeitsdruck des Gases im Rezipienten ein Kalibrierungsfaktor ermittelt wird, worauf mit einem dem Kalibrierungsfaktor proportionalen Ausgangssignal eine Gasmenge mit entsprechendem Druck in einen Kalibrierungs-Druckbehälter mit einem Volumen geringer als das Volumen des Rezipienten eingeleitet wird, und
c) dann das Gas aus dem Kalibrierungs-Druckbehälter unter isothermischen Bedingungen in den Rezipienten überführt wird, in welchem sich der vorgegebene Arbeitsdruck des Gases einstellt.

Hierbei kann dann der Arbeitsdruck des Gases im Rezipienten gemessen und dem Rechner als Ist-Signal zur Korrektur des Kalibrierungsfaktors zugeführt werden.

Zur Durchführung des Verfahrens betrifft die vorliegende Erfindung weiter eine Anlage zur Behandlung von Gütern, insbesondere zur Beschichtung von Substraten, unter Vakuum, mit einem gasdicht verschliessbaren, evakuierbaren und mit einer Atmosphäre aus inertem Gas versehbaren Rezipienten.

Diese Anlage zeichnet sich erfindungsgemäss nun aus durch eine Einrichtung zur Kalibrierung des Gasdruckes im Rezipienten für einen jeweiligen Arbeitszyklus, mit einem Kalibrierungs-Druckbehälter mit einem Volumen geringer als das Volumen des Rezipienten, welcher Kalibrierungs-Druckbehälter über ansteuerbare Ventilmittel einerseits mit einer Quelle inerten Gases und andrerseits mit dem Rezipienten strömungsverbunden ist, wobei der Rezipient und der Kalibrierungs-Druckbehälter je über einen Druckmesser mit einem Rechner verbunden sind, der über ein nachgeschaltetes Steuergerät die Ventilmittel zur Einleitung des Gases in den Kalibrierungs-Druckbehälter resp. in den Rezipienten steuert.

Eine beispielsweise Ausführungsform des erfindungsgemässen Verfahrens ist nachfolgend anhand eines Prinzipschemas der Anlage zur Durchführung des Verfahrens näher erläutert.

Die schematisch angedeutete Anlage zur Behandlung von Gütern, insbesondere zur Beschichtung von Substraten, unter Vakuum, umfasst eine gasdicht verschliessbare, evakuierbare und mit einer Atmosphäre aus inertem Gas versehbare Vakuum-Beschichtungskammer 1 (Rezipienten).

Diesem Rezipient 1 ist eine Einrichtung zur Kalibrierung des Gasdruckes im Rezipienten für einen jeweiligen Arbeitszyklus zugeschaltet, welche Einrichtung einen Kalibrierungs-Druckbehälter 2 mit einem Volumen v geringer als das Volumen V des Rezipienten 1 umfasst, welcher Kalibrierungs-Druckbehälter 2 über ansteuerbare Ventilmittel 3,4 einerseits mit einer Quelle inerten Gases 10 und andrerseits mit dem Rezipienten 1 strömungsverbunden ist.

Der Rezipient 1 und der Kalibrierungs-Druckbehälter 2 sind weiter je über einen Druckmesser 5 resp. 6 mit einem Rechner 7 verbunden, der über ein nachgeschaltetes Steuergerät 8 die Ventilmittel 3,4 zur Einleitung des Gases in den Kalibrierungs-Druckbehälter 2 resp. die Ausgleichströmung in den Rezipienten 1 steuert.

Zur Kalibrierung des Gasdruckes im gasdicht verschliessbaren, evakuierbaren und mit einer Atmosphäre aus inertem Gas versehbaren Rezipienten 1 wird für einen Arbeitszyklus der Rezipient 1 evakuiert und der Restgasdruck mit dem Druckmesser 5 gemessen, um von dort als Restgas-Signal dem Rechner 7 zugeführt zu werden.

Der Rechner 7 ermittelt dann aus dem Restgas-Signal und einem dem Rechner vorgegebenen Arbeitsdruck des Gases im Rezipienten 1 einen Kalibrierungsfaktor, worauf mit einem dem Kalibrierungsfaktor proportionalen Ausgangssignal über das Steuergerät 8 und dem Ventil 3 eine Gasmenge mit entsprechendem Druck (Pv) in den Kalibrierungs-Druckbehälter 2 eingeleitet wird.

Darauf wird das Ventil 4 angesteuert und das Gas aus dem Kalibrierungs-Druckbehälter 2 unter isothermischen Bedingungen in den Rezipienten 1 überführt, in welchem sich der vorgegebene Arbeitsdruck des Gases (P(V+v)) einstellt.

Um die isothermischen Bedingungen zu erreichen, werden hier der Kalibrierungs-Druckbehälter 2 und der Rezipient 1 über ein Heisswasserheizsystem 11 auf gleiche Temperatur gebracht und gehalten.

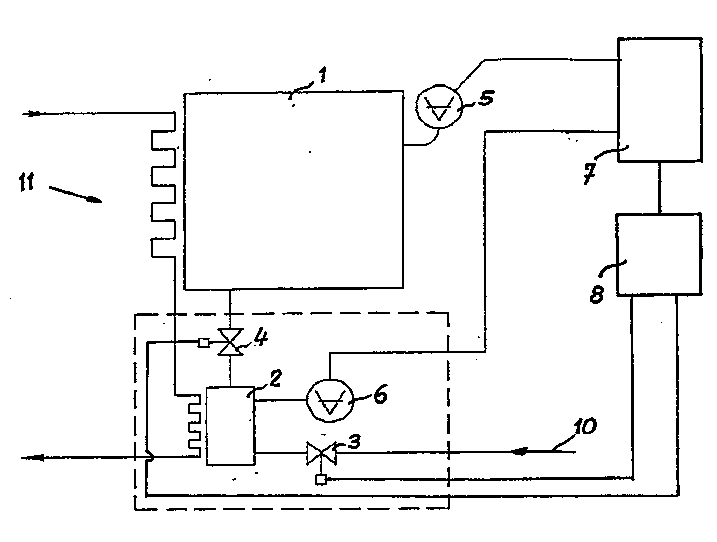

## Patentansprüche

1. Verfahren zur Kalibrierung des Gasdruckes in einem gasdicht verschliessbaren, evakuierbaren und mit einer Atmosphäre aus inertem Gas versehbaren Vakuum-Arbeitsbehälter (Vakuum-Beschichtungskammer resp. Rezipienten),
**dadurch gekennzeichnet,**
**dass**, für einen Arbeitszyklus,
a) der Rezipient evakuiert und der Restgasdruck gemessen wird, um als Restgas-Signal einem Rechner zugeführt zu werden,
b) dann mittels Rechner aus dem Restgas-Signal und einem dem Rechner vorgegebenen Arbeitsdruck des Gases im Rezipienten ein Kalibrierungsfaktor ermittelt wird, worauf mit einem dem Kalibrierungsfaktor proportionalen Ausgangssignal eine Gasmenge mit entsprechendem Druck (Pv) in einen Kalibrierungs-Druckbehälter mit einem Volumen (v) geringer als das Volumen (V) des Rezipienten eingeleitet wird, und
c) dann das Gas aus dem Kalibrierungs-Druckbehälter unter isothermischen Bedingungen in den Rezipienten überführt wird, in welchem sich der vorgegebene Arbeitsdruck des Gases (P(V+v)) einstellt.

2. Verfahren nach Anspruch 1, **dadurch gekennzeichnet, dass** dann der Arbeitsdruck des Gases im Rezipienten gemessen und dem Rechner als Ist-Signal zur Korrektur des Kalibrierungsfaktors zugeführt wird.

3. Anlage zur Behandlung von Gütern, insbesondere zur Beschichtung von Substraten, unter Vakuum, mit einem gasdicht verschliessbaren, evakuierbaren und mit einer Atmosphäre aus inertem Gas versehbaren Vakuum-Arbeitsbehälter (Rezipienten),
**gekennzeichnet durch**
eine Einrichtung zur Kalibrierung des Gasdruckes im Rezipienten für einen jeweiligen Arbeitszyklus, mit einem Kalibrierungs-Druckbehälter (2) mit einem Volumen (v) geringer als das Volumen (V) des Rezipienten (1), welcher Kalibrierungs-Druckbehälter (2) über ansteuerbare Ventilmittel (3,4) einerseits mit einer Quelle inerten Gases und andrerseits mit dem Rezipienten (1) strömungsverbunden ist, wobei der Rezipient (1) und der Kalibrierungs-Druckbehälter (2) je über einen Druckmesser (5 resp. 6) mit einem Rechner (7) verbunden sind, der über ein nachgeschaltetes Steuergerät (8) die Ventilmittel (3,4) zur Einleitung des Gases in den Kalibrierungs-Druckbehälter (2) resp. in den Rezipienten (1) steuert.

## Claims

1. A procedure for calibrating the gas pressure in a gas-tight sealable, evacuatable process vacuum chamber (receiver) that can be provided with an inert gas atmosphere, **characterized by** the fact that, for an operating cycle,
a) the receiver is degassed and the residual gas is measured, and then relayed to a computer as a residual gas signal,
b) a computer is used to determine a calibration factor from the residual gas signal and a working pressure for the gas in the receiver preset for the computer, whereupon an output signal proportional to the calibration factor is employed to introduce an amount of gas with the corresponding pressure (Pv) into a calibration pressure vessel with a volume (v) lower than the volume (V) of the receiver, and
c) the gas is transferred under isothermal conditions from the calibration pressure vessel to the receiver in which the preset working pressure of the gas (P(V+v)) comes about.

2. A procedure according to claim 1, **characterized by** the fact that the working pressure of the gas in the receiver is then measured and relayed to the computer as an actual signal for correcting the calibration factor.

3. A system for treating goods, in particular for coating optical substrates, under a vacuum, with a gas-tight sealable, evacuatable vacuum chamber (receiver) that can be provided with an inert gas atmosphere, **characterized by** a device for calibrating the gas pressure in the receiver for a respective operating cycle, with a calibration pressure vessel (2) having a volume (v) lower than the volume (V) of the receiver (1), whose calibration pressure vessel (2) is connected in terms of flow with an inert gas source and the receiver (1) via actuatable valve fittings (3,4), wherein the receiver (1) and calibration pressure vessel (2) are each linked via a pressure gauge (5 or 6) with a computer (7), which controls the valve fittings (3,4) for introducing the gas into the calibration pressure vessel (2) or receiver (1) by way of a downstream controller (8).

## Revendications

1. Procédé pour calibrer la pression du gaz dans une chambre de traitement à vide (chambre respectivement récipient de dépôt à vide) pouvant être fermée d'une manière étanche aux gaz, pouvant être évacuée et pouvant être pourvue d'une atmosphère en gaz inerte, **caractérisé**
**en ce que**, pour un cycle de travail,
a) le récipient est évacué et la pression de gaz résiduel est mesurée pour être transmise en tant que signal de gaz résiduel à un calculateur,
b) en ce qu'il est déterminé ensuite au moyen d'un calculateur, à partir du signal de gaz résiduel et d'une pression de travail du gaz entrée préalablement dans le calculateur, dans le récipient un facteur de calibrage, à la suite de quoi il est introduit avec un signal de départ proportionnel au facteur de calibrage une quantité de gaz d'une pression correspondante (Pv) dans une chambre sous pression de calibrage selon un volume (v) inférieur au volume (V) du récipient et
c) en ce que le gaz est ensuite transféré de la chambre sous pression de calibrage sous des conditions isothermiques dans le récipient dans lequel s'établit la pression de travail entrée préalablement du gaz (P(V+v)).

2. Procédé selon la revendication 1, **caractérisé en ce qu'**ensuite, la pression de travail du gaz est mesurée dans le récipient et est amenée au calculateur comme signal réel pour la correction du facteur de calibrage.

3. Installation pour le traitement de marchandises, notamment pour l'enduction de substrats, sous vide, avec une chambre de travail (récipient) à vide, pouvant être fermée d'une manière étanche aux gaz, pouvant être évacuée et pouvant être pourvue d'une atmosphère en gaz inerte, **caractérisée par** un dispositif pour le calibrage de la pression du gaz dans le récipient pour un cycle de travail respectif, avec une chambre sous pression de calibrage (2) avec un volume (v) inférieur au volume (V) du récipient (1), ladite chambre sous pression de calibrage (2) étant en liaison d'écoulement par des moyens de vanne (3, 4) pouvant être commandés, d'une part, avec une source de gaz inerte et, d'autre part, avec le récipient (1), où le récipient (1) et la chambre sous pression de calibrage (2) sont reliés chacun par un capteur de pression (5 respectivement 6) à un calculateur (7), qui commande par un appareil de commande (8) monté en aval les moyens de vanne (3, 4) pour l'introduction du gaz dans la chambre sous pression de calibrage (2) respectivement dans le récipient (1).
